(19) Europäisches Patentamt
European Patent Office
Office européen des brevets

(11) EP 4 468 399 A1

(12) **EUROPEAN PATENT APPLICATION**
published in accordance with Art. 153(4) EPC

(43) Date of publication:
27.11.2024 Bulletin 2024/48

(51) International Patent Classification (IPC):
*H01M 4/139* (2010.01)

(21) Application number: 22961818.6

(52) Cooperative Patent Classification (CPC):
H01M 4/139; Y02E 60/10

(22) Date of filing: 14.10.2022

(86) International application number:
PCT/CN2022/125519

(87) International publication number:
WO 2024/077632 (18.04.2024 Gazette 2024/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Contemporary Amperex Technology
(Hong Kong) Limited
Central, Central And Western District (HK)

(72) Inventor: LIN, Haiming
Ningde, Fujian 352100 (CN)

(74) Representative: Ziebig Hengelhaupt Intellectual
Property Attorneys
Patentanwaltskanzlei PartGmbB
Leipziger Straße 49
10117 Berlin (DE)

(54) **NEGATIVE ELECTRODE SHEET AND PREPARATION METHOD THEREFOR, AND SECONDARY BATTERY AND ELECTRIC DEVICE**

(57) The present application provides a negative electrode plate, a preparation method therefor, a secondary battery and a power consuming device. The method comprises: providing a negative electrode current collector; coating at least one surface of the negative electrode current collector with a photosensitive adhesive and curing same to form a photosensitive layer; patterning light into a preset pattern, and allowing the incidence of the light from the surface of the photosensitive layer that is away from the negative electrode current collector to the photosensitive layer to expose the photosensitive layer; developing the exposed photosensitive layer to obtain a photosensitive layer having a recessed portion; filling the recessed portion with a negative electrode slurry, and curing the negative electrode slurry to form a negative electrode film layer; and removing at least a part of the photosensitive layer to obtain the negative electrode plate. In the present application, by exposing and developing a photosensitive adhesive, the structural form and distribution form of a recessed portion in the photosensitive adhesive can be accurately adjusted and controlled, and with the aid and cooperation of the photosensitive adhesive to form a hole in a negative electrode film layer, the structure of the hole in the negative electrode film layer can be accurately adjusted and controlled, which is beneficial for improving the fast-charging performance and safety performance of a secondary battery.

*FIG. 7*

**Description**

Technical Field

The present application relates to the field of batteries, and in particular to a negative electrode plate, a preparation method therefor, a secondary battery, and a power consuming device.

Background Art

Secondary batteries have the characteristics of a high capacity, a long service life, etc., and are therefore widely used in electronic devices, such as a mobile phone, a notebook computer, an electromobile, an electric vehicle, an electric airplane, an electric ship, an electric toy car, an electric toy ship, an electric toy airplane, and an electric tool.

With an increasingly wide application range of batteries, the requirements for the performance of secondary batteries are becoming increasingly stringent. In order to improve the performance of secondary batteries, electrode plates within a secondary battery, such as a negative electrode, are usually optimized for improvements. However, when the current negative electrode plate is applied to a secondary battery, the secondary battery still has poor fast-charging ability and safety performance, which need to be further improved.

Summary

The present application has been made in view of the above problems, and an objective thereof is to provide a negative electrode plate, a preparation method therefor, a secondary battery and a power consuming device.

A first aspect of the present application provides a method for preparing a negative electrode plate, the method comprising: providing a negative electrode current collector; coating at least one surface of the negative electrode current collector with a photosensitive adhesive and curing same to form a photosensitive layer; patterning light into a preset pattern, and allowing the incidence of the light from the surface of the photosensitive layer that is away from the negative electrode current collector to the photosensitive layer to expose the photosensitive layer; developing the exposed photosensitive layer to obtain a photosensitive layer having a recessed portion; filling the recessed portion with a negative electrode slurry, and curing the negative electrode slurry to form a negative electrode film layer; and removing at least a part of the photosensitive layer to obtain the negative electrode plate.

Thus, in the present application, by exposing and developing a photosensitive adhesive, the structural form and distribution form of a recessed portion in the photosensitive adhesive can be accurately adjusted and controlled; with the aid and cooperation of the photosensitive adhesive to form a hole in a negative electrode film layer, the structure of the hole in the negative electrode film layer can be accurately adjusted and controlled; and the negative electrode film layer absorbs an electrolyte solution with the aid of the hole structure, which is beneficial to improving the transport rate of active ions in the liquid phase and the rate at which the active ions are desolvated for entering the negative electrode active substance of the negative electrode film layer, thereby improving the kinetic performance of the negative electrode plate, such that when such a negative electrode plate is applied to a secondary battery, the fast-charging performance of the secondary battery can be improved; and the improvement of the kinetic performance of the negative electrode plate can alleviate the concentration polarization problem, and active ions are less likely to precipitate locally to form dendrites, thereby improving the safety performance of a secondary battery.

In any embodiment, the step of removing at least a part of the photosensitive layer comprises that the time for removing the photosensitive layer is 10 s to 60 s; and the degree of removal degree of removal of the photosensitive adhesive can be adjusted by adjusting and controlling the treatment time.

In any embodiment, after the step of developing the photosensitive layer, the method further comprises: subjecting the developed photosensitive layer to a heat treatment, wherein optionally, the temperature for the heat treatment is 200°C to 250°C; and/or the time for the heat treatment is 10 min to 20 min. Subjecting the developed photosensitive layer to a further heat treatment can allow the further crosslinking inside the photosensitive layer, which improves the bonding performance of the photosensitive layer, thereby improving the bonding strength between the photosensitive layer and the negative electrode current collector 5211.

In any embodiment, in the step of coating at least one surface of the negative electrode current collector with a photosensitive adhesive and curing same to form a photosensitive layer, at least one of conditions (1) to (4) is satisfied: (1) the coating is carried out at a speed of 20 m/min to 70 m/min; (2) the curing temperature is 60°C to 90°C; (3) the curing time is 60 s to 90 s; and (4) the photosensitive layer comprises a positive photosensitive adhesive or a negative photosensitive adhesive.

In any embodiment, the thickness of the photosensitive layer is denoted as $T1$ μm; the thickness of the negative electrode film layer is denoted as $T2$ μm, and $1.0 \leq T1/T2 \leq 1.5$. The thickness of the photosensitive layer should be similar to that of the negative electrode film layer. This arrangement is beneficial for reproducing a preset pattern in the negative electrode film layer and assisting in the hole formation in the negative electrode film layer. Since the photosensitive adhesive is in a flowable liquid state, it is usually necessary to subject same to a heat treatment in order to cure same. The forming state of the photosensitive adhesive can be controlled by adjusting the heat treatment conditions.

In any embodiment, the step of patterning light into a preset pattern and allowing the incidence of the light from the surface of the photosensitive layer that is away from the negative electrode current collector to the photosensitive layer to expose the photosensitive layer comprises: allowing the incidence of the light from the surface of the photosensitive layer that is away from the negative electrode current collector to the photosensitive layer by using a mask, to expose the photosensitive layer; and optionally, the method further satisfies at least one of conditions (I) to (III): (I) the exposure time is 1 s to 10 s; (II) the mask comprises a plurality of holes and the hole diameter of the holes is 10 $\mu$m to 2500 $\mu$m; and (III) the distance between the mask and the photosensitive layer is 0 to 400 $\mu$m, optionally 0 to 200 $\mu$m. The degree of cross-linking and development effects of the exposed regions can be adjusted via the exposure time, and the subsequent hole formation results can be adjusted by adjusting the exposure time. By adjusting the distance between the mask and the photosensitive, the patterns of the mask in the photosensitive can be reproduced with equal scaling.

In any embodiment, the negative electrode slurry comprises a negative electrode active substance, which includes one or more of synthetic graphite, natural graphite, soft carbon, hard carbon, a silicon-based material, a tin-based material and lithium titanate.

A second aspect of the present application provides a negative electrode plate, the negative electrode plate comprising a negative electrode current collector; and a negative electrode film layer provided on at least one surface of the negative electrode current collector, wherein the negative electrode film layer comprises a first hole; wherein the size of the first hole in the thickness direction of the negative electrode plate is H1 $\mu$m; the size of the negative electrode film layer in the thickness direction of the negative electrode plate is H $\mu$m, and optionally $0.2 \leq H1/H \leq 1.0$; and further optionally, $0.5 \leq H1/H \leq 1.0$.

Thus, in the present application, the negative electrode film layer is provided with a first hole and the electrolyte solution is absorbed into the negative electrode film layer through the first hole, such that the transport rate of active ions in the liquid phase and the rate the rate at which the active ions are desolvated for entering the negative electrode active substance are improved, which can further improve the kinetic performance of the negative electrode plate, thereby improving the fast-charging performance and safety performance of a secondary battery comprising the negative electrode plate. When the above ranges are satisfied in the present application, the space occupied by the negative active substance can be ensured while improving the liquid absorption capacity, thereby ensuring the capacity per gram of the negative electrode plate.

In any embodiment, the negative electrode plate satisfies at least one of conditions (a) to (c): (a) the hole diameter of the first hole is denoted as D $\mu$m, and $10 \leq D \leq 500$, optionally $10 \leq D \leq 100$; (b) $10 \leq H1 \leq 300$; and (c) $50 \leq H \leq 300$. Thus, at least one of the above conditions is satisfied in the present application, the kinetic performance of a negative electrode plate can be further improved.

In any embodiment, a plurality of first holes are provided and the plurality of first holes are provided in a spaced manner, the distance between two adjacent first holes is denoted as W $\mu$m, and $100 \leq W \leq 1000$; and optionally, $100 \leq W \leq 200$. The distance between two adjacent holes within the above ranges can ensure the overall porosity of the negative electrode film layer, which can ensure the capacity per gram of the negative electrode plate while improving the kinetic performance of the negative electrode plate.

A third aspect of the present application provides a secondary battery comprising a negative electrode plate according to any one of embodiments in the second aspect of the present application.

A fourth aspect of the present application provides a power consuming device, comprising a secondary battery according to any one of embodiments in the third aspect of the present application.

Brief Description of the Drawings

In order to more clearly illustrate the technical solutions of the embodiments of the present application, the accompanying drawings required in the embodiments of the present application will be briefly described below. Obviously, the accompanying drawings described below are merely some embodiments of the present application, and for those of ordinary skill in the art, other accompanying drawings can be obtained from these accompanying drawings without making creative efforts.

Fig. 1 is schematic diagram 1 of an embodiment in which a negative electrode plate is prepared according to the present application.
Fig. 2 is schematic diagram 2 of an embodiment in which a negative electrode plate is prepared according to the present application.
Fig. 3 is schematic diagram 3 of an embodiment in which a negative electrode plate is prepared according to the present application.

Fig. 4 is schematic diagram 4 of an embodiment in which a negative electrode plate is prepared according to the present application.

Fig. 5 is schematic diagram 5 of an embodiment in which a negative electrode plate is prepared according to the present application.

Fig. 6 is schematic diagram 6 of an embodiment in which a negative electrode plate is prepared according to the present application.

Fig. 7 is schematic diagram 7 of an embodiment in which a negative electrode plate is prepared according to the present application.

Fig. 8 is a schematic structural diagram of an electrode assembly for a secondary battery according to the present application.

Fig. 9 is a schematic diagram of an embodiment of a secondary battery according to the present application.

Fig. 10 is an exploded schematic diagram of an embodiment of the secondary battery shown in Fig. 9.

Fig. 11 is a schematic diagram of an embodiment of a battery module according to the present application.

Fig. 12 is a schematic diagram of an embodiment of a battery pack according to the present application.

Fig. 13 is an exploded schematic diagram of an embodiment of the battery pack shown in Fig. 12.

Fig. 14 is a schematic diagram of an embodiment of a power consuming device comprising a secondary battery according to the present application as a power supply.

The accompanying drawings are not necessarily drawn to the actual scale.

List of reference signs:

1. battery pack; 2. upper box body; 3. lower box body; 4. battery module;
5. secondary battery; 51. housing; 52. electrode assembly;
521. negative electrode plate; 5211. negative electrode current collector; 5212. negative electrode film layer; 5213. first hole; 5214. photosensitive layer; 52141. recessed portion; 5215. mask
522. positive electrode plate; 523. separator;
53. cover plate;
6. power consuming device.

Detailed Description of Embodiments

Hereinafter, embodiments of a negative electrode plate and a preparation method therefor, a secondary battery and a power consuming device of the present application are specifically disclosed in the detailed description. However, unnecessary detailed illustrations may be omitted in some instances. For example, there are situations where detailed description of well-known items and repeated description of actually identical structures are omitted. This is to prevent the following description from being unnecessarily verbose, and facilitates understanding by those skilled in the art. Moreover, the accompanying drawings and the descriptions below are provided for enabling those skilled in the art to fully understand the present application, rather than limiting the subject matter disclosed in the claims.

The "ranges" disclosed in the present application are defined in the form of lower and upper limits. A given range is defined by selecting a lower limit and an upper limit, and the selected lower and upper limits defining the boundaries of the particular range. Ranges defined in this manner may be inclusive or exclusive, and may be arbitrarily combined, that is, any lower limit may be combined with any upper limit to form a range. For example, if the ranges 60-120 and 80-110 are listed for a particular parameter, it should be understood that the ranges 60-110 and 80-120 are also contemplated. Additionally, if minimum range values 1 and 2 are listed and maximum range values 3, 4, and 5 are listed, the following ranges are all contemplated: 1-3, 1-4, 1-5, 2-3, 2-4, and 2-5. In the present application, unless stated otherwise, the numerical range "a-b" denotes an abbreviated representation of any combination of real numbers between a and b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer ≥ 2, it is equivalent to disclosing that the parameter is, for example, an integer of 2, 3, 4, 5, 6, 7, 8, 9, 10, 11, 12, etc.

All the embodiments and optional embodiments of the present application can be combined with one another to form new technical solutions, unless otherwise stated. All the technical features and optional technical features of the present application can be combined with one another to form a new technical solution, unless otherwise stated.

Unless otherwise stated, all the steps of the present application may be performed sequentially or randomly, preferably sequentially. For example, the method including steps (a) and (b) indicates that the method may comprise steps (a) and (b) carried out sequentially, and may also comprise steps (b) and (a) carried out sequentially. For example, reference to "the method may further comprise step (c)" indicates that step (c) may be added to the method in any order, e.g., the method may comprise steps (a), (b) and (c), steps (a), (c) and (b), or steps (c), (a) and (b).

The terms "comprise" and "include" mentioned in the present application are open-ended or may also be closed-ended, unless otherwise stated. For example, "comprise" and "include" may mean that other components not listed may further be comprised or included, or only the listed components may be comprised or included.

In the present application, the term "or" is inclusive unless otherwise specified. For example, the phrase "A or B" means "A, B, or both A and B". More specifically, the condition "A or B" is satisfied by any one of the following: A is true (or present) and B is false (or not present); A is false (or not present) and B is true (or present); or both A and B are true (or present).

In the present application, the term "more" refers to two or more.

During the charging process of a secondary battery, a negative electrode plate needs to undergo the following electrochemical processes: (1) the active ions (e.g., lithium ions, sodium ions, etc.) deintercalated from a positive electrode active substance enter the electrolyte solution and then enter the holes of the negative electrode film layer along with the electrolyte solution to complete the liquid-phrase conduction of active ions inside the holes, where the liquid-phrase conduction includes liquid-phase diffusion; (2) the active ions exchange charges with the electrons on the surface of a negative electrode active substance; and (3) the active ions are desolvated and are solid-phase conducted to the interior of the crystals of the negative electrode active substance from the surface of the negative electrode active substance.

In a fast-charging system, active ions have relatively slow liquid-phase transport rate and desolvation rate. In order to alleviate the above problems and accelerate the liquid absorption amount of a negative electrode film layer, through holes are usually provided in a negative electrode film layer, and the electrolyte solution enters the negative electrode film layer through the through holes, which is beneficial to the liquid-phase transport of active ions.

However, the inventors found that in the related art, during a hole-forming process a hole is etched inside the negative electrode film layer by utilizing a hole-forming agent, etc. that exert an etching effect when they are volatilized. Nevertheless, the diameter of the hole prepared by means of such a hole formation method is uncontrollable, resulting in that a performance of the entire negative electrode film layer may not be uniform, active ions such as lithium ions may still have a concentration polarization problem in a local area of the negative electrode film layer, lithium ions are likely to lithium precipitation on the surface of the negative electrode film layer that faces away from the negative electrode current collector, and the precipitated lithium metal would further increase the potential barrier for lithium ions to enter the negative electrode active substance, which may further worsen the concentration polarization problem. The further precipitation of lithium ions on the surface of the negative electrode film layer may further form lithium dendrites, which may puncture the separator, causing short circuiting between the positive electrode plate and the negative electrode plate, thus causing a safety risk. Moreover, since the active ions have a relatively slow liquid-phase induction rate, the secondary battery will have a relatively poor fast-charging ability.

In view of this, the inventors propose a method for preparing a negative electrode plate, wherein a preset pattern is transferred into a negative electrode plate by means of a lithography technique and the hole formation in the negative electrode plate is assisted, such that the distribution of holes can be accurately adjusted and controlled, thereby improving the safety performance and fast-charging performance of a secondary battery in which such a negative electrode plate is applied.

## Method for preparing negative electrode plate

In a first aspect, the present application proposes a method for preparing a negative electrode plate, the method comprising:

step S 100: providing a negative electrode current collector;
step S200: coating at least one surface of the negative electrode current collector with a photosensitive adhesive and curing same to form a photosensitive layer;
step S300: patterning light into a preset pattern, and allowing the incidence of the light from the surface of the photosensitive layer that is away from the negative electrode current collector to the photosensitive layer to expose the photosensitive layer;
step S400: developing the exposed photosensitive layer to obtain a photosensitive layer having a recessed portion;
step S500: filling the recessed portion with a negative electrode slurry, and curing the negative electrode slurry to form a negative electrode film layer; and
step S600: removing at least a part of the photosensitive layer to obtain a negative electrode plate.

According to the method of an embodiment of the present application, by exposing and developing a photosensitive adhesive, the structural form and distribution form of a recessed portion in the photosensitive adhesive can be accurately adjusted and controlled; with the aid and cooperation of the photosensitive adhesive to form a hole in a negative electrode film layer, the structure of the hole in the negative electrode film layer can be accurately adjusted and controlled; and the negative electrode film layer absorbs an electrolyte solution with the aid of the hole structure, which is beneficial to improving the transport rate of active ions in the liquid phase and the rate at which the active ions are desolvated for entering the negative electrode active substance of the negative electrode film layer, thereby improving the kinetic performance of the negative electrode plate, such that when such a negative electrode plate is applied to a secondary battery, the fast-charging performance of the secondary battery can be improved; and; and the improvement of the kinetic performance of the negative electrode plate can alleviate the concentration polarization problem, and active ions are less likely to precipitate locally to form dendrites, thereby improving the safety performance of a secondary battery.

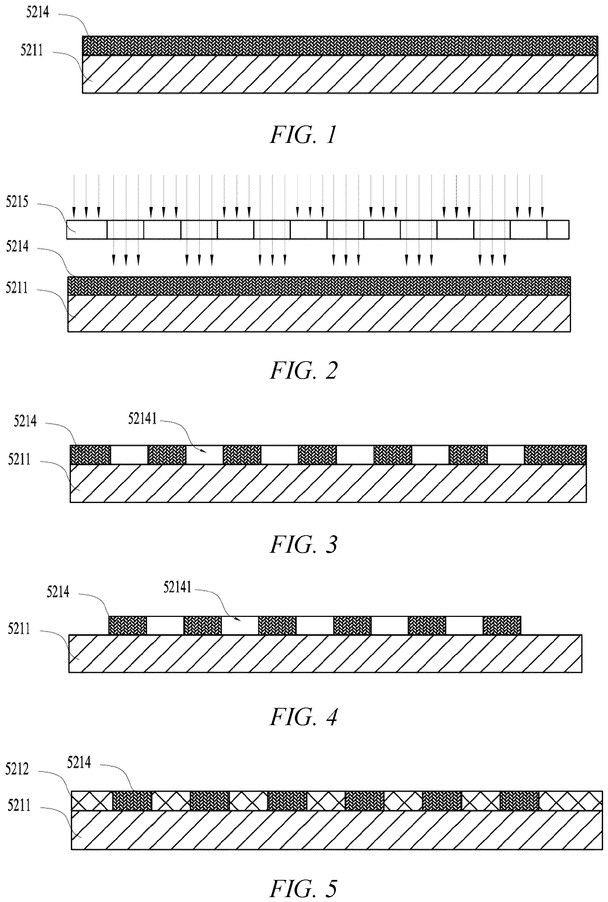

As shown in Fig. 1, in some embodiments, the negative electrode current collector 5211 in step S100 may be a metal foil or a composite current collector. For example, as a metal foil, a copper foil can be used. The composite current collector may comprise a polymer material substrate and a metal layer formed on at least one surface of the polymer material substrate. The composite current collector can be formed by forming a metal material (copper, a copper alloy, nickel, a nickel alloy, titanium, a titanium alloy, silver and a silver alloy, etc.) on a polymer material substrate (e.g., polypropylene (PP), polyethylene terephthalate (PET), polybutylene terephthalate (PBT), polystyrene (PS), polyethylene (PE), etc.).

Step S200 is a procedure of forming a photosensitive layer 5214. In some embodiments, the negative electrode current collector 5211 in step S200 comprises two surfaces opposite to each other in its own thickness direction, and the photosensitive layer 5214 can be provided on one of the two surfaces or on both surfaces. As shown in Fig. 1, one of the surfaces of the negative electrode current collector 5211 is coated with a photosensitive layer 5214.

The photosensitive layer 5214 refers to a film layer structure composed of a photosensitive polymer compound adhesive that is sensitive to light. This type of polymer compound, when exposed to external radiation sources (such as ultraviolet light with a certain radiation dose), will quickly undergo photochemical reactions, resulting in molecular cross-linking polymerization and solidification, and the molecules thereof can be transformed from the original linear structure to a three-dimensional cross-linked network structure. When being classified from different wavelengths of exposure light sources, the photosensitive adhesives include one or more of a G-line photosensitive adhesive, an I-line photosensitive adhesive, a KrF photosensitive adhesive, and a ArF photosensitive adhesive. From different dissolution positions during the development process, the photosensitive adhesives can be divided into positive photosensitive adhesives and negative photosensitive adhesives. The exposed part of a positive photosensitive adhesives will be dissolved during the development process, while the exposed part of a negative photosensitive adhesive will be insoluble during the development process, and the unexposed part will be dissolved.

Optionally, the photosensitive adhesive may be based on a photosensitive resin and further comprises a monomer cross-linking agent, a photosensitizer, a polymerization inhibitor, etc. The photosensitive adhesive has a good light transmittance and can be quickly cured and bonded to the negative electrode current collector 5211 under light source irradiation. As an example, the photosensitive adhesive may include a photopolymerizable photosensitive adhesive, a photocross-linkable photosensitive adhesive, a photodecomposable photosensitive adhesive, etc. A photopolymerizable photosensitive adhesive can be considered as a positive photosensitive adhesive, which contains an olefin monomer, which can absorb light energy to generate free radicals during the exposure, subsequently undergo cross-linking polymerization and ultimately form a polymer. A photodecomposable photosensitive adhesive can also be considered as a positive photosensitive adhesive, which can undergo photochemical reactions after absorbing light energy, causing significant changes in the affinity, solubility, etc. of a material. During the development process, the photosensitive resin will be dissolved. A photocross-linkable photosensitive adhesive can be considered as a negative photosensitive adhesive, which comprises polyvinyl laurate. During exposure, the double bonds in the molecule thereof are destroyed, and a cross-linking reaction occurs between the chains, forming a stable network structure, which allows the exposed part thereof to be insoluble in the developing solution. The specific material types of the above-mentioned types of photosensitive adhesives can be selected from commonly used materials in the prior art, and will not be described herein again.

In some embodiments, the negative electrode current collector 5211 is coated with a photosensitive adhesive at a coating speed of 20 m/min to 70 m/min. By adjusting and controlling the coating speed of the photosensitive adhesive, the coating amount of the photosensitive adhesive can be adjusted, such that the thickness of the photosensitive layer 5214 formed by the photosensitive adhesive can be adjusted. As an example, the coating speed may be 20 m/min, 25 m/min, 30 m/min, 35 m/min, 40 m/min, 45 m/min, 50 m/min, 60 m/min and 70 m/min, or in a range composed of any two of the above values.

Since the photosensitive adhesive is in a flowable liquid state, it is usually necessary to subject same to a heat treatment in order to cure same, for example, the photosensitive adhesive is placed in an oven for baking; and optionally, the curing temperature is 60°C to 90°C; and/or the curing time is 60 s to 90 s. As an example, the curing temperature may be 60°C, 65°C, 70°C, 75°C, 80°C, 85°C and 90°C, or in a range composed of any two of the above values. The curing time may be 60 s, 65 s, 70 s, 75 s, 80 s, 85 s and 90 s, or in a range composed of any two of the above values. The above curing temperature and curing time can be combined randomly. For example, the curing temperature is 60°C, and the curing time may be 90 s.

Optionally, the thickness of the photosensitive layer 5214 is denoted as T1 $\mu$m; and the thickness of the negative electrode film layer 5212 is denoted as T2 $\mu$m, and $1.0 \leq T1/T2 \leq 1.5$.

The thickness of the photosensitive layer 5214 should be similar to that of the negative electrode film layer 5212. This arrangement is beneficial for reproducing a preset pattern in the negative electrode film layer 5212 and assisting in the hole formation in the negative electrode film layer 5212. As an example, T1/T2 may be 1.0, 1.1, 1.2, 1.3, 1.4 and 1.5, or in a range composed of any two of the above values.

Step S300 is a procedure of exposing the photosensitive layer 5214. The preset pattern refers to the incident area of light that is adjusted and controlled according to the required distribution form of holes to be provided in the negative electrode film layer 5212. Since photosensitive adhesives include positive photosensitive adhesives and negative photosensitive adhesives, the preset pattern may be the same as the exposed region when a positive photosensitive adhesive is used; and the preset pattern may be the same as the unexposed region when a negative photosensitive adhesive is used. Fig. 2 shows an exposure process, and the arrows in Fig. 2 represent the incident direction of light.

Exposure is to make a difference between the exposed and unexposed regions in the photosensitive adhesive, which is beneficial for the subsequent development. The exposure time not only determines the degree of cross-linking and development effect of the exposed regions, but also affects the definition of the patterns formed in the photosensitive adhesive. The reasons are as follows: if the exposure time is too long, it may cause excessive cross-linking of the photosensitive adhesive in the exposed regions, resulting in the cross-linking of the photosensitive adhesive at the boundary between the exposed and unexposed regions; and if the exposure time is too short, it may cause insufficient cross-linking of the photosensitive adhesive in the exposed regions. Optionally, the exposure time may be 1 s to 10 s. As an example, the exposure time may be 1 s, 2 s, 3 s, 4 s, 5 s, 6 s, 7 s, 8 s, 9 s and 10 s, or in a range composed of any two of the above values.

In some embodiments, there are various exposure light sources, such as full-spectrum ultraviolet (300 nm to 450 nm), G-line (436 nm), I-line (365 nm), deep-ultraviolet (DUV, including 248 nm and 193 nm), and extreme ultraviolet (EUV). The corresponding light source for the photosensitive adhesive is selected based on the type of the photosensitive adhesive. For example, when the photosensitive adhesive is a G-line photosensitive adhesive, the exposure light source is selected from a G-line light source correspondingly. For another example, when the photosensitive adhesive is a KrF photosensitive adhesive, the exposure light source is selected from a deep-ultraviolet light source correspondingly. The light intensity may be 40 mj/cm$^2$ to 75 mj/cm$^2$. As an example, the light intensity may be 40 mj/cm$^2$, 45 mj/cm$^2$, 50 mj/cm$^2$, 55 mj/cm$^2$, 60 mj/cm$^2$, 65 mj/cm$^2$, 70 mj/cm$^2$ and 75 mj/cm$^2$, or in a range composed of any two of the above values. By cooperating of the exposure time and the exposure light intensity with each other, the definition of the patterns formed in the photosensitive adhesive can be adjusted and controlled.

To facilitate the exposure process, a mask 5215 is usually used for cooperation, for example, a metal template with through holes is used, and the hole diameter thereof may be 10 $\mu$m to 2500 $\mu$m; and the distance between the mask 5215 and the photosensitive layer 5214 may be 0 to 400 $\mu$m, optionally 0 to 200 $\mu$m. By adjusting the distance between the mask 5215 and the photosensitive layer 5214, the patterns in the mask 5215 in the photosensitive layer 5214 can be reproduced with equal scaling.

The setting of the mask 5215 is related to the preset pattern, and an adapted mask 5215 is selected according to the required preset pattern. Optionally, the holes in the mask 5215 are of various forms, such as regular polygonal holes, irregular polygonal holes, circular holes, elliptical holes, etc. Specifically, the holes may be rhombic holes, rectangular holes, triangular holes, elliptical holes, etc.

Step S400 is a development procedure, involving subjecting the exposed photosensitive layer 5214 and a developing solution to a chemical reaction to obtain a photosensitive layer 5214 with a recessed portion 52141. Specifically, the exposed regions of a positive photosensitive adhesive can be reacted with a developing solution and be dissolved and washed away, and the unexposed regions of a negative photosensitive adhesive can be reacted with a developing solution and be dissolved and washed away, such that corresponding recesses or through holes are left in the photosensitive layer 5214. As an example, the developing solution may include tetramethylammonium hydroxide, n-butyl acetate or a 0.4% KOH solution. Fig. 3 shows a development process in which a positive photosensitive adhesive is used, and Fig. 4 shows a development process in which a negative photosensitive adhesive is used.

The method may further comprises a step S700 of subjecting the developed photosensitive layer 5214 to a heat treatment after step S400. By subjecting the developed photosensitive layer 5214 to a further heat treatment, the further crosslinking can occur inside the photosensitive layer 5214, which improves the bonding performance of the photosensitive layer 5214, thus improving the bonding strength between the photosensitive layer 5214 and the negative electrode current collector 5211. Optionally, the temperature for the heat treatment is 200°C to 250°C; and/or the time for the heat treatment is 10 min to 20 min. As an example, the temperature for the heat treatment may be 200°C, 210°C, 220°C, 230°C, 240°C and 250°C, or in a range composed of any two of the above values. The time for the heat treatment may be 10 min, 11 min, 12 min, 13 min, 14 min, 15 min, 16 min, 17 min, 18 min, 19 min and 20 min, or in a range composed of any two of the above values. The above temperature and time for the heat treatment can be combined randomly. For example, the temperature of the heat treatment is 200°C, and the time for the heat treatment may be 20 min.

Step S500 is a procedure of preparing a negative electrode film layer 5212. The photosensitive layer 5214 is coated with a negative electrode slurry, followed by curing procedures of drying, cold pressing, etc. to form a negative electrode film layer 5212, and the recessed portion 52141 are filled with the negative electrode slurry and the negative electrode slurry is dried to form the negative electrode film layer 5212. Fig. 5 shows a procedure of preparing a negative electrode film layer 5212, which is an preparation schematic diagram only, in which the thickness ratio of the layers does not represent the structure of the negative electrode plate 521.

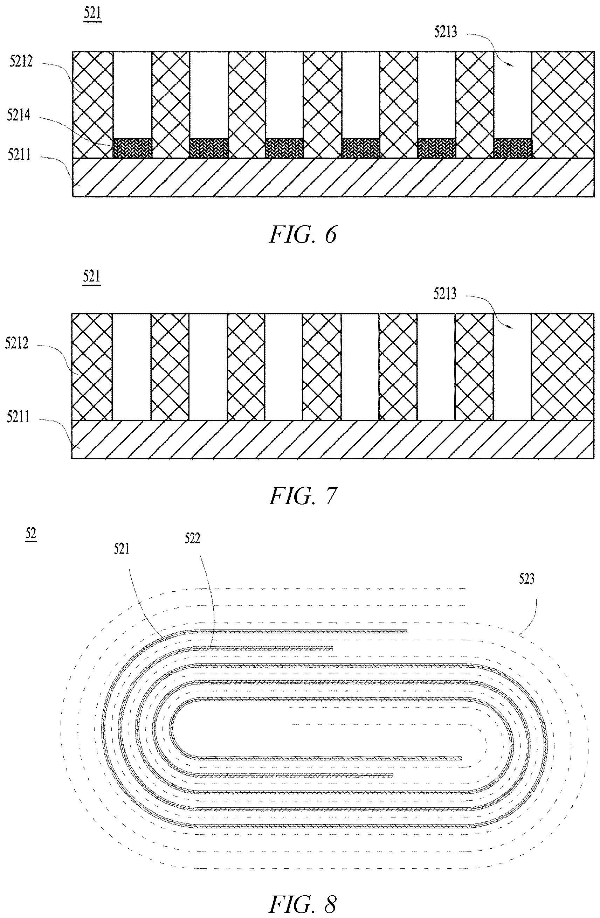

Step S600 is an adhesive removal procedure, involving removing the photosensitive adhesive that does not react with the developing solution and exposing a part of the negative electrode current collector 5211. Certainly, it is also possible that the photosensitive adhesive is not completely removed and a part of the photosensitive adhesive remains on the surface of the negative electrode current collector 5211, which is equivalent to removing a part of the photosensitive layer 5214 in the thickness direction of the negative electrode plate 521. In some embodiments, the photosensitive adhesive can be removed by means of a wet or dry adhesive removal method. For example, a remover, such as $O_2/N_2$ plasma, $Cl_2/HBr$, a hydroxylamine compound and a $H_2O$ buffered $HF/HNO_3$ solution, is used and reacted with the photosensitive layer 5214 in the negative electrode plate 521 to dissolve or ash the photosensitive adhesive, without reacting with the negative electrode active substance. After the above treatment, the photosensitive layer 5214 can be fully removed, or the photosensitive layer 5214 can also be partially removed, with another part being retained. Optionally, the treatment time may be 10 s to 60 s, and the degree of removal of the photosensitive adhesive can be adjusted by adjusting and controlling the treatment time. The degree of removal of the photosensitive adhesive can also be adjusted by adjusting and controlling the concentration of a remover. Fig. 6 shows an adhesive removal process, in which the adhesive is not fully removed, a part of the photosensitive layer 5214 is retained, and the first hole 5213 is a blind hole. Fig. 7 shows another adhesive removal process, in which the adhesive is fully removed, and the first hole 5213 is a straight through hole.

In the present application, the straight through hole refers to a through hole that penetrates through the negative electrode film layer 5212 in the thickness direction of the negative electrode plate 521. There is basically no residual photosensitive layer 5214 in the negative electrode plate 521; and the blind hole refers to a hole structure that does not penetrate through the negative electrode film layer 5212.

The existence of the first hole 5213 in the negative electrode film layer 5212 is beneficial to the absorption the electrolyte solution into the negative electrode film layer 5212 through the first hole 5213, which increases the liquid absorption amount of the negative electrode plate 521, accelerates the liquid-phase transport rate of active ions, enables the active ions to undergo desolvation more quickly to enter the negative electrode active substance of the negative electrode film layer 5212 and increases the transport rate of active ions in the system, such that the kinetic performance of the negative electrode plate 521 can be improved and the risk of the occurrence of concentration polarization is reduced, thereby improving the safety performance and fast-charging performance of a secondary battery comprising the negative electrode plate 521.

In some embodiments, the negative electrode slurry comprises a negative electrode active substance, which may be one for batteries that is well known in the art. As an example, the negative electrode active substance may include at least one of the following materials: synthetic graphite, natural graphite, soft carbon, hard carbon, a silicon-based material, a tin-based material and lithium titanate, etc. The silicon-based material may be selected from at least one of elemental silicon, a silicon oxide, a silicon carbon composite, a silicon nitrogen composite, and a silicon alloy. The tin-based material may be selected from at least one of elemental tin, a tin oxide, and a tin alloy. However, the present application is not limited to these materials, and other conventional materials that can be used as negative electrode active substances for batteries can also be used. These negative electrode active substances may be used alone or in combination of two or more.

In some embodiments, the negative electrode slurry further comprises optionally a negative electrode binder. The negative electrode binder may be selected from at least one of a styrene butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA) and carboxymethyl chitosan (CMCS).

In some embodiments, the negative electrode slurry further comprises optionally a conductive agent. The conductive agent may be selected from at least one of superconductive carbon, acetylene black, carbon black, Ketjen black, carbon dots, carbon nanotubes, graphene, and carbon nanofibers.

In some embodiments, the negative electrode slurry further comprises optionally other auxiliary agents, such as a thickener (e.g., sodium carboxymethylcellulose (CMC-Na)).

## Negative electrode plate 521

A second aspect of the present application further provides a negative electrode plate 521. The negative electrode plate 521 can be prepared by a method in any one of the embodiments in the first aspect of the present application.

In some embodiments, the negative electrode plate 521 comprises a negative electrode current collector 5211 and a negative electrode film layer 5212 provided on at least one surface of the negative electrode current collector 5211, wherein the negative electrode film layer 5212 comprises a first hole 5213, and the size of the first hole 5213 in the thickness direction of the negative electrode plate 521 is H1 $\mu$m; and the size of the negative electrode film layer 5212 in the thickness direction of the negative electrode plate 521 is H $\mu$m, and $0.2 \leq H1/H \leq 1.0$; and optionally, $0.5 \leq H1/H \leq 1.0$.

H1/H = 1 denotes that the first hole 5213 is a straight through hole penetrating through the negative electrode film layer 5212. H1/H < 1 denotes that the first hole 5213 does not completely penetrate through the negative electrode film layer 5212. In this case, it can be considered that there is still a residual photosensitive layer 5214 between the first hole 5213 and the negative electrode current collector 5211, the photosensitive layer 5214 being located in the negative electrode film layer 5212 and provided on the surface of the negative electrode current collector 5211. As an example, H1/H may be 0.2, 0.3, 0.4, 0.5, 0.6, 0.7, 0.8, 0.9 and 1, or in a range composed of any two of the above values.

In the present application, the negative electrode film layer 5212 is provided with a first hole 5213 and the electrolyte solution is absorbed into the negative electrode film layer 5212 through the first hole 5213, such that the transport rate of active ions in the liquid phase and the rate at which the active ions are desolvated for entering the negative electrode active substance are improved, which can further improve the kinetic performance of the negative electrode plate 521, thereby improving the fast-charging performance and safety performance of a secondary battery comprising the negative electrode plate 521. When the above ranges are satisfied in the present application, the space occupied by the negative active substance can be ensured while improving the liquid absorption capacity, thereby ensuring the capacity per gram of the negative electrode plate 521.

The inventors have found that the hole diameter and distribution form of the first hole 5213 and the negative electrode film layer 5212 also have an effect on the liquid-phase transport of active ions to a certain extent. When at least one of the following conditions is satisfied, the kinetic performance of the negative electrode plate 521 can be further improved.

In some embodiments, $50 \leq H \leq 300$. As an example, the size of the negative electrode film layer 5212 in the thickness direction, that is, the depth of the first hole 5213, may be 50 $\mu$m, 60 $\mu$m, 80 $\mu$m, 100 $\mu$m, 120 $\mu$m, 150 $\mu$m, 180 $\mu$m, 200 $\mu$m, 250 $\mu$m and 300 $\mu$m, or in a range composed of any two of the above values.

The size of the negative electrode film layer 5212 in the thickness direction within the above ranges can ensure the capacity per gram of the negative electrode plate 521.

In some embodiments, $10 \leq H1 \leq 300$. As an example, the size of the first hole 5213 in the thickness direction, that is, the depth of the first hole 5213, may be 10 $\mu$m, 20 $\mu$m, 50 $\mu$m, 80 $\mu$m, 100 $\mu$m, 120 $\mu$m, 150 $\mu$m, 180 $\mu$m, 200 $\mu$m, 250 $\mu$m and 300 $\mu$m, or in a range composed of any two of the above values. In the present application, the depth of the first hole 5213 is less than or equal to the thickness of the negative electrode film layer 5212.

If the depth of the first hole 5213 is too small, it is not conducive to liquid absorption; if the depth of the hole is too large, the active ions may be directly precipitated on the negative electrode current collector 5211; and if the depth of the first hole 5213 is within a suitable range, it is beneficial to the absorption of the electrolyte solution, thus improving the kinetic performance of the negative electrode plate 521.

In some embodiments, the hole diameter of the first hole 5213 is denoted as D $\mu$m, and $10 \leq D \leq 500$, optionally $10 \leq D \leq 100$. As an example, the hole diameter of the first hole 5213 may be 10 $\mu$m, 20 $\mu$m, 50 $\mu$m, 80 $\mu$m, 100 $\mu$m, 120 $\mu$m, 150 $\mu$m, 180 $\mu$m, 200 $\mu$m, 300 $\mu$m, 400 $\mu$m and 500 $\mu$m, or in a range composed of any two of the above values.

If the hole diameter of the hole diameter of the first hole 5213 is too small, it is not conducive to liquid absorption; if the hole diameter is too large, the space occupied by the negative electrode active substance is too small, which is not beneficial to ensuring the capacity per gram of the negative electrode plate 521; and if the hole diameter is within a suitable range, it is beneficial to the absorption of the electrolyte solution, thus improving the kinetic performance of the negative electrode plate 521 and ensuring the capacity per gram of the negative electrode plate 521.

In some embodiments, a plurality of first holes 5213 are provided and the plurality of first holes 5213 are provided in a spaced manner, the distance between two adjacent first holes is denoted as W $\mu$m, and $100 \leq W \leq 1000$; and optionally, $100 \leq W \leq 200$. As an example, the three adjacent holes can form a regular triangle, and the distance between two adjacent holes may be adjusted as W $\mu$m $\geq 100$ $\mu$m. As an example, the distance between two adjacent holes may be 100 $\mu$m, 150 $\mu$m, 200 $\mu$m, 250 $\mu$m, 300 $\mu$m, 400 $\mu$m, 450 $\mu$m, 500 $\mu$m, 600 $\mu$m, 700 $\mu$m, 800 $\mu$m, 900 $\mu$m and 1000 $\mu$m, or in a range composed of any two of the above values.

The distance between two adjacent holes within the above ranges can ensure the overall porosity of the negative electrode film layer 5212, which can ensure the capacity per gram of the negative electrode plate 521 while improving the kinetic performance of the negative electrode plate 521.

## Secondary battery

In a third aspect, the present application proposes a secondary battery. The secondary battery 5 comprises a negative electrode plate 521 according to any one of the embodiments in the second aspect of the present application, which can allow the fast-charging performance and safety performance of the secondary battery to be improved.

[Positive electrode plate]

The secondary battery 5 further comprises a positive electrode plate 522.

In some embodiments, the positive electrode plate 522 comprises a positive electrode current collector and a positive electrode film layer provided on at least one surface of the positive electrode current collector. For example, the positive electrode current collector has two opposite surfaces in the thickness direction thereof, and the positive electrode film layer is provided on either or both of the two opposite surfaces of the positive electrode current collector.

The positive electrode film layer comprises a positive electrode active substance, which may be one for secondary batteries that is well known in the art. As an example, the positive electrode active substance may include at least one of the following materials: a layered-structure positive electrode active substance (e.g., ternary lithium/sodium nickelate, lithium/sodium cobaltate, lithium/sodium manganate and lithium/sodium-rich layered, and rock salt phase layered materials), an olivine-type phosphate active substance, and a spinel-structured positive electrode active substance (e.g., spinel-type lithium manganate, spinel-type lithium nickel manganate, lithium-rich spinel-type lithium manganate and lithium nickel manganate, etc.).

As an example, the layered-structure positive electrode active substance has a general formula of $Li_xA_yNi_{a-}Co_bMn_cM_{(1-a-b-c)}Y_z$, wherein $0 \leq x \leq 2.1$, $0 \leq y \leq 2.1$, and $0.9 \leq x+y \leq 2.1$; $0 \leq a \leq 1$, $0 \leq b \leq 1$, $0 \leq c \leq 1$, and $0.1 \leq a+b+c \leq 1$; $1.8 \leq z \leq 3.5$; A is selected from one or more of Na, K, and Mg; M is selected from one or more of B, Mg, Al, Si, P, S, Ca, Sc, Ti, V, Cr, Fe, Cu, Zn, Sr, Y, Zr, Nb, Mo, Cd, Sn, Sb, Te, Ba, Ta, W, Yb, La and Ce; and Y is selected from one or two of O and F. Optionally, $y = 0$. Specifically, the layered-structure positive electrode active substance may include one or more of lithium cobaltate (LCO), lithium nickelate (LNO), lithium manganate (LMO), $LiNi_{1/3}Co_{1/3}Mn_{1/3}O_2$ (NCM333), $L1Ni_{0.8}Co_{0.1}Mn_{0.1}O_2$ (NCM811) and $LiNi_{0.5}Co_{0.2}Mn_{0.3}O_2$ (NCM523).

As an example, the olivine-type phosphate active substance has a general formula of $Li_xA_yMe_aM_bP_{1-c}X_cY_z$, wherein $0 \leq x \leq 1.3$, $0 \leq y \leq 1.3$, and $0.9 \leq x+y \leq 1.3$; $0.9 \leq a \leq 1.5$, $0 \leq b \leq 0.5$, and $0.9 \leq a+b \leq 1.5$; $0 \leq c \leq 0.5$; $3 \leq z \leq 5$; A is selected from one or more of Na, K, and Mg; Me is selected from one or more of Mn, Fe, Co and Ni; M is selected from one or more of B, Mg, Al, Si, P, S, Ca, Sc, Ti, V, Cr, Cu, Zn, Sr, Y, Zr, Nb, Mo, Cd, Sn, Sb, Te, Ba, Ta, W, Yb, La and Ce; X is selected from one or more of S, Si, Cl, B, C and N; and Y is selected from one or two of O and F. Specifically, the olivine-type phosphate active substance includes one or more of $LiFePO_4$, $LiMnPO_4$, $LiNiPO_4$, and $LiCoPO_4$.

As an example, the spinel-structured positive electrode active substance has a general formula of $Li_xA_yMn_aM_{2-a}Y_z$, wherein $0 \leq x \leq 2$, $0 \leq y \leq 1$, and $0.9 \leq x+y \leq 2$; $0.5 \leq a \leq 2$; $3 \leq z \leq 5$; A is selected from one or more of Na, K, and Mg; M is selected from one or more of Ni, Co, B, Mg, Al, Si, P, S, Ca, Sc, Ti, V, Cr, Fe, Cu, Zn, Sr, Y, Zr, Nb, Mo, Cd, Sn, Sb, Te, Ba, Ta, W, Yb, La and Ce; and Y is selected from one or two of O and F. Specifically, the spinel-structured positive electrode active substance includes one or more of $LiMn_2O_4$, $LiNi_{0.5}Mn_{1.5}O_4$, $LiCr_{0.3}Mn_{1.7}O_4$, $Li_{1.1}Al_{0.1}Mn_{1.9}O_4$, $Li_2Mn_2O_4$ and $Li_{1.5}Mn_2O_4$.

In some embodiments, the positive electrode film layer further comprises optionally a positive electrode conductive agent. In the present application, the type of the positive electrode conductive agent is not particularly limited. As an example, the positive electrode conductive agent includes one or a combination of more selected from superconducting carbon, conductive graphite, acetylene black, carbon black, Ketjen black, carbon dots, carbon nanotubes, graphene and carbon nanofibers. In some embodiments, the mass percentage content of the positive electrode conductive agent is 5% or less, based on the total mass of the positive electrode film layer.

In some embodiments, the positive electrode film layer further comprises optionally a positive electrode binder. In the present application, the type of the positive electrode binder is not particularly limited. As an example, the positive electrode binder may include one or a combination of more selected from polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer and a fluorine-containing acrylate resin. In some embodiments, the mass percentage content of the positive electrode binder is 5% or less, based on the total mass of the positive electrode film layer.

In some embodiments, the positive electrode current collector may be a metal foil or a composite current collector. As an example of a metal foil, an aluminum foil or an aluminum alloy foil can be used. The composite current collector may comprise a polymer material substrate and a metal material layer formed on at least one surface of the polymer material substrate. As an example, the metal material may include one or a combination of more selected from aluminum, an aluminum alloy, nickel, a nickel alloy, titanium, a titanium alloy, silver and a silver alloy; and the polymer material substrate may include one or a combination of more selected from polypropylene (PP), polyethylene terephthalate (PET), polybutylene terephthalate (PBT), polystyrene (PS) and polyethylene (PE).

The positive electrode film layer is typically formed by coating a positive electrode slurry on the positive electrode current collector, followed by drying and cold pressing. The positive electrode slurry is typically formed by dispersing a positive electrode active substance, an optional conductive agent, an optional binder and any other components into a solvent and stirring same uniformly. The solvent may be N-methylpyrrolidone (NMP), but is not limited thereto.

[Electrolyte]

The secondary battery 5 further comprises an electrolyte.

The electrolyte functions to conduct ions between the positive electrode plate 522 and the negative electrode plate 521. The type of the electrolyte is not specifically limited in the present application and can be selected as necessary. For example, the electrolyte may be in a liquid state, a gel state or an all-solid state.

In some embodiments, an electrolyte solution is used as the electrolyte. The electrolyte solution comprises an electrolyte salt and a solvent.

In some embodiments, an electrolyte solution is used as the electrolyte. The electrolyte solution comprises an electrolyte salt and a solvent.

As an example, an lithium salt may include one or a combination of more selected from lithium hexafluorophosphate ($LiPF_6$), lithium tetrafluoroborate ($LiBF_4$), lithium perchlorate ($LiClO_4$), lithium hexafluoroarsenate ($LiAsF_6$), lithium bisfluorosulfonimide (LiFSI), lithium bistrifluoromethanesulfonimide (LiTFSI), lithium trifluoromethanesulfonate (LiTFS), lithium difluorooxalate borate (LiDFOB), lithium dioxalate borate (LiBOB), lithium difluorophosphate ($LiPO_2F_2$), lithium bisoxalatodifluorophosphate (LiDFOP) and lithium tetrafluorooxalate phosphate (LiTFOP).

As an example, the organic solvent may include one or a combination of more selected from ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), dimethyl sulfone (MSM), ethyl methyl sulfone (EMS) and diethyl sulfone (ESE).

In some embodiments, the electrolyte solution further comprises optionally an additive. For example, the additive may include a negative electrode film-forming additive and a positive electrode film-forming additive, and may further include an additive that can improve certain performances of the battery, such as an additive that improves the overcharge performance of the battery, or an additive that improves the high temperature or low-temperature performance of the battery.

[Separator]

The secondary battery further comprises a separator 523.

In some embodiments, the secondary battery 5 further comprises a separator 523. The type of the separator 523 is not particularly limited in the present application, and any well-known porous-structure separator 523 with good chemical stability and mechanical stability may be selected.

In some embodiments, the material of the separator 523 may be selected from at least one of glass fibers, non-woven fabrics, polyethylene, polypropylene and polyvinylidene fluoride. The separator 523 may be either a single-layer film or a multi-layer composite film, and is not limited particularly. When the separator 523 is a multi-layer composite film, the materials in the respective layers may be same or different, which is not limited particularly.

As shown in Fig. 8, in some embodiments, a positive electrode plate 522, a negative electrode plate 521 and a separator 523 may be subjected to a winding process or a laminating process to form an electrode assembly 52.

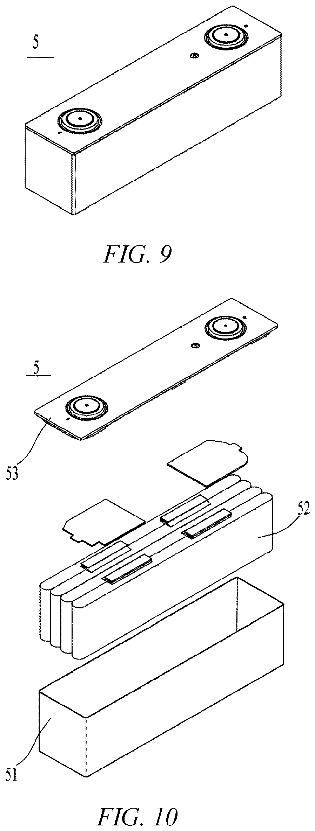

The shape of the secondary battery is not particularly limited in the present application and may be cylindrical, square or of any other shape. Fig. 9 shows a secondary battery 5 with a square structure as an example.

In some embodiments, as shown in Figs. 9 and 10, the outer package may comprise a housing 51 and a cover plate 53. Herein, the housing 51 may comprise a bottom plate and side plates connected to the bottom plate, and the bottom plate and the side plates enclose to form an accommodating cavity. The housing 51 has an opening in communication with the accommodating cavity, and the cover plate 53 is used for covering the opening to close the accommodating cavity. The positive electrode plate, the negative electrode plate, and the separator may be subjected to a winding process or a laminating process to form an electrode assembly 52. The electrode assembly 52 is packaged in the accommodating cavity. The electrolyte solution is infiltrated into the electrode assembly 52. The number of the electrode assemblies 52 contained in the secondary battery 5 may be one or more, and may be adjusted according to requirements.

The method for preparing the secondary battery 5 of the present application is well-known. In some embodiments, a positive electrode plate, a separator, a negative electrode plate, and an electrolyte solution may be assembled to form a secondary battery 5. As an example, a positive electrode plate, a separator, and a negative electrode plate may be subjected to a winding process or a laminating process to form an electrode assembly, the electrode assembly is placed in an outer package and dried, an electrolyte solution is then injected, and the electrode assembly is subjected to procedures such as vacuum packaging, standing, forming, and shaping to obtain a secondary battery 5.

In some embodiments of the present application, the secondary battery 5 according to the present application may be assembled into a battery module, the number of the secondary batteries 5 contained in the battery module may be multiple, and the specific number may be adjusted according to the application and capacity of the battery module.

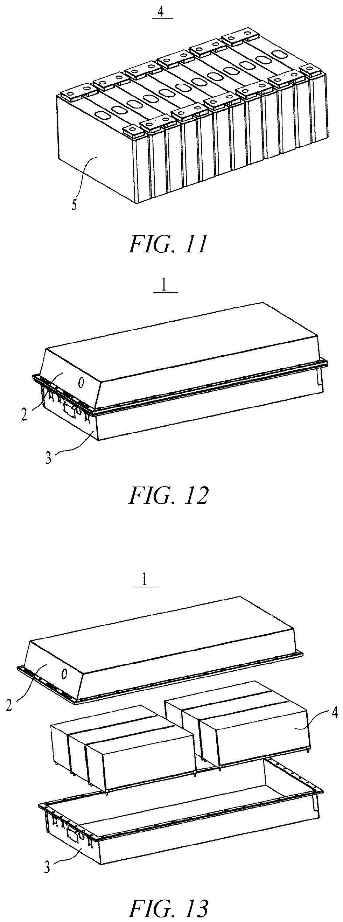

Fig. 11 shows a schematic diagram of a battery module 4 as an example. As shown in Fig. 11, in the battery module 4, a plurality of secondary batteries 5 may be arranged in sequence in the length direction of the battery module 4. Apparently, the secondary batteries may also be arranged in any other manner. Furthermore, the plurality of secondary batteries 5 may be fixed by fasteners.

Optionally, the battery module 4 may further comprise an outer housing with an accommodating space, and the plurality of secondary batteries 5 are accommodated in the accommodating space.

In some embodiments, the above battery module may also be assembled into a battery pack, and the number of the battery modules contained in the battery pack may be adjusted according to the application and capacity of the battery pack.

Figs. 12 and 13 show a schematic diagram of a battery pack 1 as an example. As shown in Figs. 12 and 13, the battery pack 1 may comprise a battery box and a plurality of battery modules 4 arranged in the battery box. The battery box comprises an upper box body 2 and a lower box body 3, and the upper box body 2 is used to cover the lower box body 3 to form a closed space for accommodating the battery modules 4. A plurality of battery modules 4 may be arranged in the battery box in any manner.

### Power consuming device

In a fourth aspect, the present application provides a power consuming device comprising at least one of a secondary battery, a battery module and a battery pack of the present application. The secondary battery, the battery module and the battery pack may be used as a power supply or an energy storage unit of the power consuming device. The power consuming device may be, but is not limited to, a mobile apparatus (e.g., a mobile phone, a laptop computer, etc.), an electric vehicle (e.g., a pure electric vehicle, a hybrid electric vehicle, a plug-in hybrid electric vehicle, an electric bicycle, an electric scooter, an electric golf vehicle, an electric truck, etc.), an electric train, a ship, a satellite, an energy storage system, etc.

A secondary battery, battery module or battery pack may be used for the power consuming device according to the usage requirements thereof.

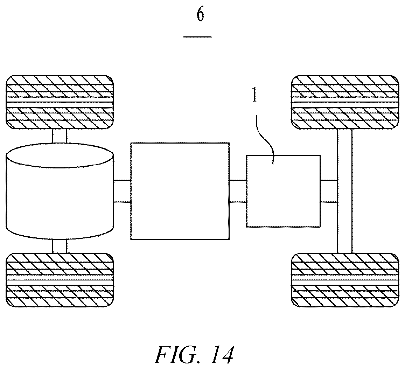

Fig. 14 shows a schematic diagram of a power consuming device as an example. The power consuming device 6 may be a pure electric vehicle, a hybrid electric vehicle, a plug-in hybrid electric vehicle, etc. In order to meet the requirements of the power consuming device for a high power and a high energy density, a battery pack 1 or a battery module may be used.

As another example, the power consuming device may be a mobile phone, a tablet computer, a laptop computer, etc. The power consuming device is generally required to be thin and light, and may have a secondary battery used as a power supply.

### Examples

Hereinafter the examples of the present application will be explained. The examples described below are exemplary and are merely for explaining the present application, and should not be construed as limiting the present application. The examples in which techniques or conditions are not specified are based on the techniques or conditions described in documents in the art or according to the product instructions. The reagents or instruments used therein on which no manufacturers are specified are all commercially available conventional products.

Example 1

1. Preparation of positive electrode plate

An aluminum foil having a thickness of 12 $\mu$m was used as a positive electrode current collector.

A positive electrode active substance, a conductive agent of carbon black, and a binder of polyvinylidene fluoride (PVDF) were fully stirred and mixed in an appropriate amount of a solvent of NMP at a weight ratio of 97.5 : 1.4 : 1.1, to form a uniform positive electrode slurry; and the positive electrode slurry was uniformly coated onto the surface of the positive electrode current collector of an aluminum foil, followed by drying and cold pressing to obtain a positive electrode plate.

2. Preparation of negative electrode plate

A copper foil having a thickness of 8 $\mu$m was used as a negative electrode current collector.

The negative electrode current collector was coated with a positive photosensitive adhesive (the specific components thereof including an epoxy resin DER331J, a polyurethane modified epoxy resin EPU-10, crylic acid, oxalic acid anhydride, benzyltriethylammonium chloride, hydroquinone, phthalic anhydride, and benzoin ethyl ether) at a coating speed of 50 m/min, and after the coating is complete, same is baked in an oven at a temperature of 60°C for 120 s, such that the photosensitive adhesive was cured into a photosensitive layer.

Under the cover of a mask, the photosensitive layer was irradiated with an ultraviolet ray (with a wavelength of 365 nm) having a light intensity of 65 mj/cm$^2$, wherein the exposure time was 5 s. The mask was a metal template with circular holes having a hole diameter of 2 mm.

The exposed photosensitive adhesive was sprayed with a developing solution of tetramethylammonium hydroxide at a spraying speed of 20 to 70 m/min and a flow rate of 0.1 to 1 L/min; such that the exposed regions of the positive photosensitive adhesive were dissolved, and same are washed away, thus leaving a cylindrical hole array in the photosensitive layer.

The developed photosensitive layer was subjected to a heat treatment at a temperature of 250°C for 10 min.

A negative electrode active substance of synthetic graphite, a conductive agent of carbon black, a binder of styrene butadiene rubber (SBR), and a thickener of sodium hydroxymethyl cellulose (CMC) were fully stirred and mixed in an appropriate amount of a solvent of deionized water at a weight ratio of 96.8 : 0.7 : 1.3 : 1.2 to form a uniform negative electrode slurry. The negative electrode slurry was coated onto the holes of the photosensitive layer, followed by drying and cold pressing to form a negative electrode film layer.

A $H_2O$ buffered $HF/HNO_3$ solution (with a concentration of 3 wt%/20 wt%) was reacted with the photosensitive adhesive in the negative electrode plate for 50 s, such that the photosensitive adhesive was dissolved. After the treatment, the negative electrode film layer was formed with first hole, and the negative electrode film layer having the first hole and the negative electrode current collector formed a negative electrode plate.

3. Separator

A porous polyethylene (PE) film was used as a separator.

4. Preparation of electrolyte solution

In an environment with a water content of less than 10 ppm, non-aqueous organic solvents of ethylene carbonate (EC) and diethyl carbonate (DMC) were mixed at a volume ratio of 1 : 1 to obtain a solvent of an electrolyte solution, and then a lithium salt was mixed with the mixed solvent to formulate an electrolyte solution with a lithium salt concentration of 1 mol/L.

5. Preparation of secondary battery

The above positive electrode plate, separator and negative electrode plate were stacked in sequence, such that the separator was located between the positive electrode plate and the negative electrode plate to play a role of isolation, and then the stack was wound to obtain an electrode assembly; and the electrode assembly was placed in an outer packaging housing and dried, and then the electrolyte solution was injected, followed by the procedures such as vacuum encapsulation, leaving to stand, forming and shaping to obtain a lithium ion battery.

Example 2

A lithium ion battery was prepared by a method similar to that in Example 1, except that during the preparation of negative electrode plates in examples 2-1 to 2-3, the reaction time between the $H_2O$ buffered $HF/HNO_3$ solution and the photosensitive layer in a negative electrode plate was adjusted to adjust the depth of the holes.

Comparative example 1

In comparative example 1, a lithium ion battery was prepared by a method similar to that in Example 1, except that the process of preparing a negative electrode plate was adjusted in comparative example 1, and the process of preparing a negative electrode plate was as follows:

A copper foil having a thickness of 8 $\mu$m was used as a negative electrode current collector.

A negative electrode active substance of synthetic graphite, a conductive agent of carbon black, a binder of a styrene butadiene rubber (SBR), and a thickener of sodium hydroxymethyl cellulose (CMC) were fully stirred and mixed in an appropriate amount of a solvent of deionized water at a weight ratio of 96.8 : 0.7 : 1.3 : 1.2 to form a uniform negative electrode slurry. The negative electrode slurry was coated onto a surface of the negative electrode current collector, followed by drying and cold pressing to obtain a negative electrode film layer.

Relevant parameters of examples 1 and 2 and comparative example 1 are as shown in Table 1:

Table 1

| No. | Adhesive removal time/s | H1/$\mu$m | H/$\mu$m | H1/H | Charging time T/min |
|---|---|---|---|---|---|
| Example 1 | 50 | 120 | 150 | 0.8 | 17.0 |
| Example 2-1 | 35 | 30 | 150 | 0.2 | 21.5 |
| Example 2-2 | 40 | 75 | 150 | 0.5 | 20.0 |
| Example 2-3 | 60 | 150 | 150 | 1.0 | 16.5 |
| Comparative example 1 | / | / | 150 | / | 30.0 |

In Table 1, the adhesive removal time refers to the reaction time between the $H_2O$ buffered HF/HNO$_3$ solution and the photosensitive layer in a negative electrode plate. H1 represents the size of the first hole in the thickness direction of the negative electrode plate (a depth of H1). H represents the size of the negative electrode film layer in the thickness direction of the negative electrode plate (a thickness of H).

It can be seen from Table 1 that no artificial hole was made in the negative electrode film layer of comparative example 1, and the battery has a risk of concentration polarization and has a poor kinetic performance and fast-charging performance. Compared with comparative example 1, holes were formed by means of an etching process in examples of the present application, which can reduce the risk of concentration polarization and improve the kinetic performance, such that the fast-charging performance and the safety performance are improved.

Example 3

In example 3, a lithium ion battery was prepared by a method similar to that in example 1, except that the specifications of the coated masks in examples 3-1 to 3-6 were adjusted. The specification of a mask would influence the parameter of the hole diameter of first hole.

Relevant parameters of examples 1 and 3 are as shown in Table 2.

Table 2

| No. | H1/H | Hole diameter of mask/mm | Distance between mask and photosensitive layer/$\mu$m | Hole diameter of first hole D/$\mu$m | Distance between two adjacent holes W/$\mu$m | Charging time T/min |
|---|---|---|---|---|---|---|
| Example 1 | 0.8 | 2 | 150 | 20 | 100 | 17.0 |
| Example 3-1 | 0.8 | 2 | 160 | 10 | 100 | 17.5 |
| Example 3-2 | 0.8 | 2 | 100 | 100 | 100 | 19.0 |
| Example 3-3 | 0.8 | 2 | 80 | 300 | 100 | 19.5 |
| Example 3-4 | 0.8 | 2 | 50 | 500 | 100 | 20.5 |
| Example 3-5 | 0.8 | 1.5 | 100 | 20 | 150 | 18.0 |
| Example 3-6 | 0.8 | 1 | 100 | 20 | 200 | 18.5 |

It can be seen from Table 2 that the structure of the holes in a negative electrode film layer can be adjusted by adjusting the specification of the mask, such that the fast-charging ability and safety performance of a secondary battery are adjusted.

Example 4

In example 4, a lithium ion battery was prepared by a method similar to that in Example 1, except that in example 4, no heat treatment was carried out after developing during the preparation of a negative electrode plate, and the specific process of preparing a negative electrode plate was as follows:

A copper foil having a thickness of 8 $\mu$m was used as a negative electrode current collector.

The negative electrode current collector was coated with a positive photosensitive adhesive (the specific components thereof including: an epoxy resin DER331J, a polyurethane modified epoxy resin EPU-10, crylic acid, oxalic acid anhydride, benzyltriethylammonium chloride, hydroquinone, phthalic anhydride, and benzoin ethyl ether) at a coating speed of 50 m/min, and after the coating is complete, same is baked in an oven at a temperature of 60°C for 120 s, such that the photosensitive adhesive was cured into a photosensitive layer.

Under the cover of a mask, the photosensitive layer was irradiated with an ultraviolet ray (with a wavelength of 365 nm) having a light intensity of 65 mj/cm$^2$, wherein the exposure time was 5 s. The mask was a metal template with circular holes having a hole diameter of 2 mm.

The exposed photosensitive adhesive was sprayed with a developing solution of tetramethylammonium hydroxide at a spraying speed of 20 to 70 m/min, and a flow rate of 0.1 to 1 L/min; such that the exposed regions of the positive photosensitive adhesive were dissolved, and same are washed away, thus leaving a cylindrical hole array in the photosensitive layer.

A negative electrode active substance of synthetic graphite, a conductive agent of carbon black, a binder of a styrene butadiene rubber (SBR), and a thickener of sodium hydroxymethyl cellulose (CMC) were fully stirred and mixed in an appropriate amount of a solvent of deionized water at a weight ratio of 96.8 : 0.7 : 1.3 : 1.2 to form a uniform negative electrode slurry. The negative electrode slurry was coated onto the holes in the photosensitive layer, followed by drying and cold pressing to form a negative electrode film layer.

A $H_2O$ buffered $HF/HNO_3$ solution (with a concentration of 3 wt%/20 wt%) was used to react with the photosensitive layer in the negative electrode plate for 60 s such that the photosensitive adhesive was dissolved. After the treatment, the negative electrode film layer was formed with first hole, and the negative electrode film layer having the first hole and the negative electrode current collector formed a negative electrode plate.

Relevant parameters of examples 1 and 4 are as shown in Table 3:

Table 3

| No. | H1/H | Test of bonding strength between negative electrode current collector and photosensitive adhesive | Charging time T/min |
|---|---|---|---|
| Example 1 | 0.8 | 15N/m | 17.0 |
| Example 4 | 0.8 | 10 N/m | 18.0 |

It can be seen from Table 3 that the formed photosensitive layer in example 4 is not subjected to a heat treatment, while that in example 1 is subjected to a heat treatment, which can allow the photosensitive layer to further crosslinking and increase the bonding strength between the negative electrode current collector and the photosensitive layer, such that the negative electrode plate has a better internal structure stability and the layers are less prone to peel off and released, which is beneficial for improving the fast-charging performance of the secondary battery.

**Test part**

**I. Test of parameters of negative electrode plates**

1. Thickness H of negative electrode film layer and depth of H1 of first hole

The thickness of a negative electrode plate was measured at at least 12 different positions of the negative electrode plate along the thickness direction with a ten-thousandth micrometer, and then the average was taken as the thickness h1 of the negative electrode plate; and then the thickness of the negative electrode current collector is subtracted to obtain the thickness of the negative electrode film layer.

2. Hole diameter and depth H1 of first hole and distance between two adjacent first holes

A scanning electron microscope (SEM) (SEM model: Thermo Scientific Apreo 2) may be used for observation and measurement.

**II. Test of parameters of secondary batteries**

1. Test of fast-charging performance of secondary battery

At 25°C, the secondary batteries prepared above were charged at a constant current of 0.33 C to a charge cut-off voltage of 4.4 V, then charged at the constant voltage until the current was 0.05 C, left to stand for 5 min and then discharged at a constant current of 0.33 C to a discharge cut-off voltage of 2.8 V; the actual capacity thereof was recorded as C0.

Then, the secondary batteries were charged to a full-battery charge cut-off voltage of 4.4 V at a constant current of 0.5 C0, 1 C0, 1.5 C0, 2 C0, 2.5 C0, 3 C0, 3.5 C0, 4 C0 and 4.5 C0 in sequence; after each charging was completed, the batteries should be discharged at 1 C0 to a full-battery discharge cut-off voltage of 2.8 V, and the corresponding negative electrode potentials were recorded when the batteries were charged to 10%, 20%, 30%, ..., and 80% SOC (State of Charge) at different charge rates; the rate - negative electrode potential curves in different SOC states were plotted, followed by linear fitting to obtain the corresponding charge rates when the negative electrode potentials were 0 V in different SOC states, where the charge rates were the charging windows in the SOC states, donated as C10% SOC, C20% SOC, C30% SOC, C40% SOC, C50% SOC, C60% SOC, C70% SOC and C80% SOC respectively; and the charging time T for charging the secondary batteries from 10% SOC to 80% SOC was calculated according to a formula (60/C20% SOC + 60/C30% SOC + 60/C40% SOC + 60/C50% SOC + 60/C60% SOC + 60/C70% SOC + 60/C80% SOC) × 10%. A shorter charging time T indicates a better fast-charging performance of a secondary battery.

Although the present application has been described with reference to the preferred embodiments, various modifications can be made, and equivalents can be provided to substitute for the components thereof without departing from the scope of the present application. In particular, the technical features mentioned in the embodiments can be combined in any manner, provided that there is no structural conflict. The present application is not limited to the specific embodiments disclosed herein but includes all the technical solutions that fall within the scope of the claims.

**Claims**

1.  A method for preparing a negative electrode plate, comprising:

    providing a negative electrode current collector;
    coating at least one surface of the negative electrode current collector with a photosensitive adhesive and curing same to form a photosensitive layer;
    patterning light into a preset pattern, and allowing the incidence of the light from the surface of the photosensitive layer that is away from the negative electrode current collector to the photosensitive layer to expose the photosensitive layer;
    developing the exposed photosensitive layer to obtain a photosensitive layer having a recessed portion;
    filling the recessed portion with a negative electrode slurry, and curing the negative electrode slurry to form a negative electrode film layer; and
    removing at least a part of the photosensitive layer to obtain the negative electrode plate.

2.  The method according to claim 1, wherein the step of removing at least a part of the photosensitive layer comprises: the time for removing the photosensitive layer being 10 s to 60 s.

3.  The method according to claim 1 or 2, wherein after the step of developing the photosensitive layer, the method further comprises: subjecting the developed photosensitive layer to a heat treatment, wherein optionally the temperature for the heat treatment is 200°C to 250°C; and/or the time for the heat treatment is 10 min to 20 min.

4.  The method according to any one of claims 1 to 3, wherein in the step of coating at least one surface of the negative electrode current collector with a photosensitive adhesive and curing same to form a photosensitive layer, at least one of conditions (1) to (4) is satisfied:

    (1) the coating is carried out at a speed of 20 m/min to 70 m/min;
    (2) the curing temperature is 60°C to 90°C;
    (3) the curing time is 60 s to 90 s; and
    (4) the photosensitive layer comprises a positive photosensitive adhesive or a negative photosensitive adhesive.

5.  The method according to any one of claims 1 to 4, wherein
    the thickness of the photosensitive layer is denoted as $T1$ μm; the thickness of the negative electrode film layer is denoted as $T2$ μm; and

$$1.0 \leq T1/T2 \leq 1.5$$

6. The method according to any one of claims 1 to 5, wherein the step of patterning light into a preset pattern and allowing the incidence of the light from the surface of the photosensitive layer that is away from the negative electrode current collector to the photosensitive layer to expose the photosensitive layer comprises

allowing the incidence of the light from the surface of the photosensitive layer that is away from the negative electrode current collector to the photosensitive layer by using a mask, to expose the photosensitive layer; and optionally, the method further satisfies at least one of conditions (I) to (III):

(I) the exposure time is 1 s to 10 s;
(II) the mask comprises a plurality of holes, which have a diameter of 10 $\mu$m to 2500 $\mu$m; and
(III) the distance between the mask and the photosensitive layer is 0 to 400 $\mu$m, optionally 0 to 200 $\mu$m.

7. The method according to any one of claims 1 to 6, wherein the negative electrode slurry comprises a negative electrode active substance, which includes one or more of synthetic graphite, natural graphite, soft carbon, hard carbon, a silicon-based material, a tin-based material and lithium titanate.

8. A negative electrode plate prepared by a method according to any one of claims 1 to 7, comprising:

a negative electrode current collector; and
a negative electrode film layer provided on at least one surface of the negative electrode current collector, the negative electrode film layer comprising a first hole,
wherein,
the size of the first hole in the thickness direction of the negative electrode plate is H1 $\mu$m;
the size of the negative electrode film layer in the thickness direction of the negative electrode plate is H $\mu$m; and
optionally $0.2 \leq H1/H \leq 1.0$; and further optionally, $0.5 \leq H1/H \leq 1.0$.

9. The negative electrode plate according to claim 8, wherein the negative electrode plate satisfies at least one of conditions (a) to (c):

(a) the hole diameter of the first hole is denoted as D $\mu$m, and $10 \leq D \leq 500$, optionally $10 \leq D \leq 100$;
(b)

$$10 \leq H1 \leq 300;$$

and
(c)

$$50 \leq H \leq 300$$

10. The negative electrode plate according to claim 8 or 9, wherein
a plurality of first holes are provided and the plurality of first holes are provided in a spaced manner, and the distance between two adjacent first hole is denoted as W $\mu$m, and $100 \leq W \leq 1000$; and optionally, $100 \leq W \leq 200$.

11. A secondary battery, comprising a negative electrode plate according to any one of claims 8 to 10.

12. A power consuming device, comprising a secondary battery according to claim 11.

5214

5211

*FIG. 1*

5215

5214

5211

*FIG. 2*

5214

52141

5211

*FIG. 3*

5214

52141

5211

*FIG. 4*

5212

5214

5211

*FIG. 5*

521

5212

5213

5214

5211

*FIG. 6*

521

5212

5213

5211

*FIG. 7*

52

521    522

523

*FIG. 8*

FIG. 9

FIG. 10

*FIG. 11*

*FIG. 12*

*FIG. 13*

6

1

*FIG. 14*

<div align="center">**INTERNATIONAL SEARCH REPORT**</div>

| International application No. |
|---|
| **PCT/CN2022/125519** |

**A.    CLASSIFICATION OF SUBJECT MATTER**

H01M4/139(2010.01)i

According to International Patent Classification (IPC) or to both national classification and IPC

**B.    FIELDS SEARCHED**

Minimum documentation searched (classification system followed by classification symbols)

IPC:H01M

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 电池, 锂, 光敏, 负极, 阳极, 曝光, 显影, 凹部, 孔, 热处理, 交联, 粘结, 结合强度, batter???, cell?, Li, lithium, photosensitive, exposure, develop, concave, hole, pore, heat+, cross w linked, bind+, strength

**C.    DOCUMENTS CONSIDERED TO BE RELEVANT**

| Category* | Citation of document, with indication, where appropriate, of the relevant passages | Relevant to claim No. |
|---|---|---|
| X | KR 20170002348 A (LG CHEMICAL LTD.) 06 January 2017 (2017-01-06) description, paragraphs 3-4 and 67-77, and figures 1-2 | 1-2, 4-12 |
| Y | KR 20170002348 A (LG CHEMICAL LTD.) 06 January 2017 (2017-01-06) description, paragraphs 3-4 and 67-77, and figures 1-2 | 3 |
| Y | JP H03168214 A (HITACHI LTD.) 22 July 1991 (1991-07-22) abstract, and claims 1-7 | 3 |
| A | JP 2008103259 A (IDEMITSU KOSAN CO,. LTD. et al.) 01 May 2008 (2008-05-01) entire document | 1-12 |
| A | KR 20130085828 A (SK INNOVATION CO., LTD.) 30 July 2013 (2013-07-30) entire document | 1-12 |
| A | WO 2006077676 A1 (MITSUI MINING & SMELTING CO., LTD. et al.) 27 July 2006 (2006-07-27) entire document | 1-12 |

☐ Further documents are listed in the continuation of Box C.          ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 June 2023** | **08 June 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2022/125519**

| Patent document cited in search report | | | Publication date (day/month/year) | Patent family member(s) | | | Publication date (day/month/year) |
|---|---|---|---|---|---|---|---|
| KR | 20170002348 | A | 06 January 2017 | KR | 101735251 | B1 | 12 May 2017 |
| JP | H03168214 | A | 22 July 1991 | JP | 2644599 | B2 | 25 August 1997 |
| JP | 2008103259 | A | 01 May 2008 | | None | | |
| KR | 20130085828 | A | 30 July 2013 | KR | 101876402 | B1 | 09 July 2018 |
| WO | 2006077676 | A1 | 27 July 2006 | JP | 2006202658 | A | 03 August 2006 |

Form PCT/ISA/210 (patent family annex) (July 2022)